Europäisches Patentamt

European Patent Office

Office européen des brevets

(11) Publication number: **0 428 067 A2**

# EUROPEAN PATENT APPLICATION

(21) Application number: **90121380.1**

(22) Date of filing: **08.11.90**

(51) Int. Cl.5: **H01L 27/06, H01L 21/82**

(30) Priority: **10.11.89 JP 291206/89**

(43) Date of publication of application:
**22.05.91 Bulletin 91/21**

(84) Designated Contracting States:
**DE FR GB**

(71) Applicant: **Kabushiki Kaisha Toshiba**
**72, Horikawa-cho Saiwai-ku**
**Kawasaki-shi(JP)**

(72) Inventor: **Taguchi, Minoru, Intellectual**
**Property Division**
**Kabushiki Kaisha Toshiba, 1-1 Shibaura**
**1-chome**
**Minato-ku, Tokyo 105(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) Semiconductor integrated circuit and method of manufacturing the same.

(57) In a semiconductor integrated circuit wherein a bipolar transistor and an insulated gate type complementary transistor are formed on a single semiconductor chip, the insulated gate type complementary transistor is formed in an island-shaped epitaxial layer (4) which is completely isolated from a semiconductor substrate (1) and the other part of the circuit and which has a conductivity type (N) opposite to that (P) of the semiconductor substrate, and an electrode (176) is formed in contact with a region (62) for isolating the islandshaped epitaxial layer from the other part of the circuit. In the semiconductor integrated circuit, since the CMOS circuit is formed in the island-shaped epitaxial layer isolated completely from the semiconductor substrate and the other part of the circuit, noise occurring in the CMOS circuit does not adversely affect the bipolar circuit. Thus, the operation margin of the semiconductor integrated circuit is increased, and the malfunction of the circuit can be prevented.

F I G. 2C

## SEMICONDUCTOR INTE RATED CIRCUIT AND METHOD OF MANUFACTURING THE SAME

The present invention relates generally to a semiconductor integrated circuit and a method of manufacturing the same, and in particularly to a bi-CMOS type semiconductor integrated circuit wherein a bipolar transistor and an insulated gate type complementary MOS transistor are integrated on a single chip, and a method of manufacturing this integrated circuit.

A recent development in reducing the size and power consumption of electronic devices is remarkable. This development is greatly owing to semiconductor technology. In the field of semiconductor integrated circuits (ICs), a large-scale integration and a highspeed operation are advancing rapidly. In particular, attention has been drawn to the technique relating to a Bi-CMOS technique having both the features of a bipolar transistor, such as high-driving ability, high-speed operation and high analog characteristic, and the features of a CMOS transistor, such as high integration density and low power consumption.

According to the Bi-CMOS technique, a circuit part of a bipolar transistor and a circuit of a CMOS transistor are formed commonly on a single semiconductor substrate. Compared to the analog operation of the bipolar circuit, the digital operation of the CMOS circuit causes a greater variation in voltage; con sequently, noise is liable to occur. In order to prevent noise occurring in the CMOS circuit from adversely affecting the bipolar circuit, the following patterning techniques have been conventionally adopted: to provide a power line and a ground line separately for the bipolar circuit and for the CMOS circuit, or to separate both circuits sufficiently. These techniques, however, have failed to bring about good results.

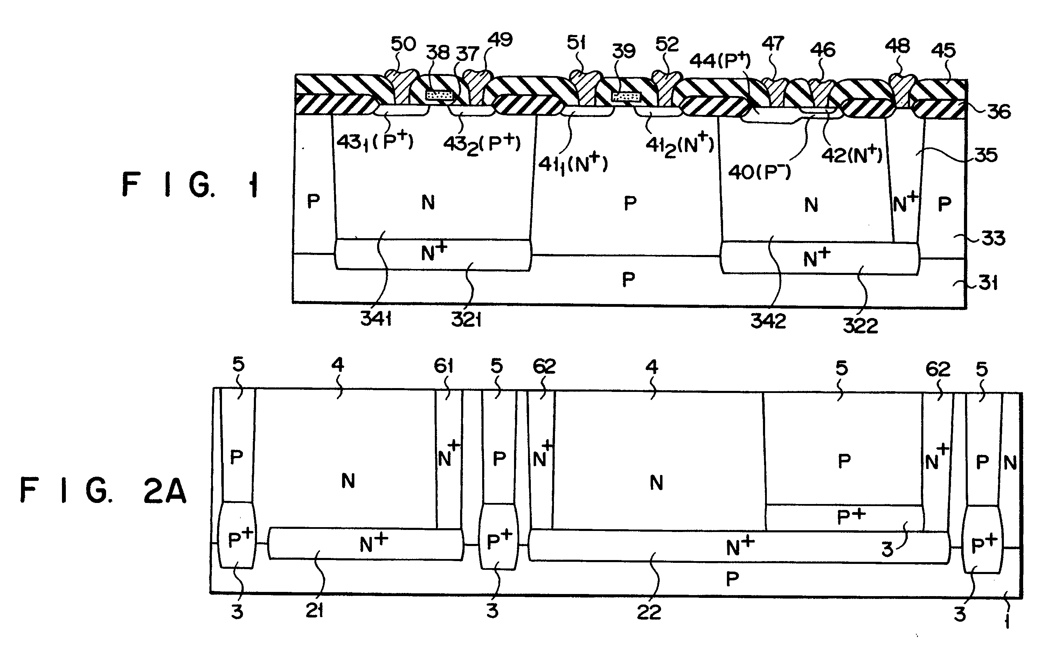

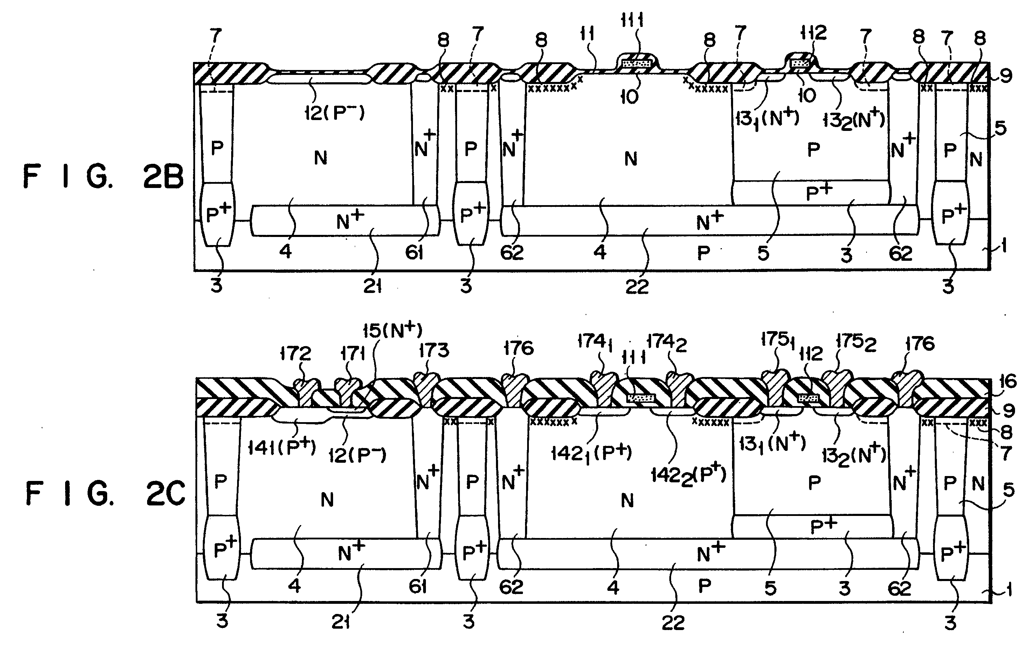

Fig. 1 shows a cross-sectional structure of a conventional Bi-CMOS integrated circuit. Reference numeral 31 denotes a P-type silicon substrate; 321 and 322 $N^+$ buried layers; 33 a P-type epitaxial layer; 341 a a first N-well diffusion layer, formed within the epitaxial layer 33 and on the $N^+$ buried layer 321, for the formation of a P-channel MOS transistor; 342 a second N-well diffusion layer, formed within the epitaxial layer 33 and on the $N^+$ buried layer 322, for the formation of an NPN transistor; 35 a deep $N^+$ diffusion layer extending from the surface of the second N-well diffusion layer 342 to the $N^+$ buried layer 322; 36 an element isolation region (field oxide film); 37 a gate oxide film; 38 a gate electrode of the P-channel MOS transistor; 39 a gate electrode of an N-channel MOS transistor; 40 an internal base region (P-diffusion layer) of the NPN transistor; $41_1$ and $42_2$ a drain region and a source region ($N^+$ diffusion layers) of the N-channel transistor; 42 an emitter region ($N^+$ region) of the NPN transistor; $43_1$ and $43_2$ a drain region and a source region ($P^+$, diffusion layers) of the P-channel transistor; 44 an external base region ($P^+$ diffusion layer) of the NPN transistor; 45 an interlayer insulating film; 46 and 47 an emitter electrode and a base electrode of the NPN transistor; 48 a collector electrode put in contact with the deep $N^+$ diffusion layer 35; 49 and 50 a drain electrode and a source electrode of the P-channel transistor; and 51 and 52 a drain electrode and a source electrode of the N-channel transistor.

As has been stated above, in the conventional Bi-CMOS integrated circuit, in order to prevent noise occurring in the CMOS circuit from adversely affecting the bipolar circuit, the patterning techniques have been adopted. For example, a power line and a ground line are provided separately for the bipolar circuit and for the CMOS circuit, or both circuits are separated from each other sufficiently. These techniques, however, have failed to bring about good results.

The present invention has been devised in consideration of the above problem, and its object is to provide a semiconductor integrated circuit and a method of manufacturing the same, wherein noise occurring in a CMOS circuit is prevented from adversely affecting a bipolar circuit, and the manufacture of the circuit is relatively easy, and the number of manufacturing processes can be reduced.

The present invention provides a semiconductor integrated circuit wherein a bipolar transistor and an insulated gate type complementary transistor are formed on a single semiconductor chip, characterized in that said insulated gate type complementary transistor is formed in an island-shaped epitaxial layer which is completely isolated from a semiconductor substrate and the other part of the circuit and which has a conductivity type opposite to that of the semiconductor substrate, and that an electrode is formed in contact with a region for isolating said island-shaped epitaxial layer from the other part of the circuit.

In addition, this invention provides a method of manufacturing a semiconductor integrated circuit wherein a bipolar transistor and an insulated gate type complementary transistor are formed on a single semiconductor chip, said method comprising the steps of: forming an island portion in an epitaxial layer formed in a surface portion of a semiconductor substrate and having a conductivity type opposite to that of the semiconductor substrate, said island portion being isolated completely from the semiconductor substrate and the other part of the circuit; forming an insulated gate type complementary transistor in said isalnd portion in the epitaxial layer; and forming an electrode in contact with a region for isolating said island portion from the other part of the circuit.

According to the present invention, the CMOS circuit is formed in the island-shaped epitaxial layer isolated completely from the semiconductor substrate and the other part of the circuit. Thus, noise occurring in the CMOS circuit does not adversely affect the bipolar circuit. While the operation margin of the semiconductor integrated circuit is increased, the malfunction of the circuit can be prevented. In addition, it is not necessary to make special patterning, e.g. to provide the power line and ground line separately for the bipolar circuit and the CMOS circuit, or to separate both circuits with a sufficient distance. Thus, the integration density can be increased and the number of external pins can be reduced. Furthermore, since the electrode is formed in contact with the region for isolating the island-shaped epitaxial layer of the CMOS transistor region from the other part, the potential of the island-shaped epitaxial layer can be determined independently from that of the other part, by applying a desired potential to the electrode.

Moreover, according to the method of manufacturing the semiconductor integrated circuit of the present invention, the semiconductor integrated circuit having the above features can be manufactured by the combination of the well-known processes.

This invention can be more fully understood from the following detailed description when taken in conjunction with the accompanying drawings, in which:

Fig. 1 is a cross-sectional view showing a conventional Bi-CMOS integrated circuit;

Figs. 2A to 2C are cross-sectional views illustrating an example of a process of manufacturing a Bi-CMOS integrated circuit according to an embodiment of the present invention; and

Fig. 3 is a cross-sectional view showing a Bi-CMOS integrated circuit according to another embodiment of the invention.

Embodiments of the present invention will now be described in detail with reference to the accompanying drawings.

Figs. 2A to 2C illustrate an example of a process of manufacturing a Bi-CMOS integrated circuit according to an embodiment of the present invention. First, as shown in Fig. 2A, a P-type silicon substrate 1 with about 25 Ω.cm is oxidized at a temperature of 1000°C, thereby forming an oxide film (not shown) with a thickness of about 0.8 $\mu$ on the substrate 1. The resultant structure is subjected to a photoetching process (PEP), thus removing part of the oxide film. Using the oxide film as a mask, antimony (Sb) is doped to form first and second $N^+$ buried layers 21 and 22 each having 20 Ω/□. Then, the oxide film is removed, and an oxide film (not shown) with a thickness of 1000 Å is formed under an oxidation treatment at a temperature of 1000°C. Thereafter, using a photoresist pattern as a mask, boron (B) ions are implanted to form $P^+$ buried layers 3 on part of the second $N^+$ buried layer 22 and between the $N^+$ buried layers 21 and 22. Then, the oxide film is removed, and phosphorus (P) doped N-type epitaxial layers 4 are grown on the substrate. In this case, the resistivity $\rho$VG of each epitaxial layer 4 is set to about 1.5 Ω.cm, and the thickness tVG thereof is set to about 3 $\mu$m. Subsequently, an oxide film (not shown) with a thickness of 500 Å is formed by an oxidation treatment at a temperature of 1000°C. Using a photoresist pattern as a mask, boron ions are implanted in a predetermined area, and, using another photoresist pattern as a mask, phosphorus ions are implanted in a predetermined area. The oxide film is removed and an undoped CVD oxide film having a thickness of about 3000 Å is formed on the substrate by means of CVD (chemical vapor deposition). Then, a thermal diffusion treatment is carried out at a temperature of 1150°C. Thus, a P-well diffusion layer 5 extending to the $P^+$ buried layer 3, a first deep $N^+$ diffusion layer 61 extending to the first deep $N^+$ buried layer 21, and a second deep $N^+$ diffusion layer 62 extending to the second $N^+$ buried layer and surrounding the CMOS transistor region are formed.

The CVD oxide film is removed, and an oxidation treatment is performed at a temperature of 1000°C to form an oxide film (not shown) with a thickness of about 900 Å and subsequently a silicon nitride film (not shown) with a thickness of about 2000 Å is formed thereon. That portion of the silicon nitride film, which is not located on the activation region, is removed. Using a photoresist pattern for the formation of an element isolation region as a mask, a $P^-$ field inversion preventing layer 7 and an $N^-$ field inversion preventing layer 8 are formed, as shown in Fig. 2B. Then, using the silicon nitride film as a mask, a field oxide film ($SiO_2$ film) 9 with a thickness of 9000 Å is formed (not shown) with the thickness of 900 Å and the silicon nitride film (not shown) are removed, and a thin oxide film ($SiO_2$ film) 11 having a thickness of about 400 Å, part of which serves as a gate oxide film 10, is formed by a heat treatment at 950°C. An undoped polycrystalline silicon ("polysilicon") film with a thickness of 4000 Å is formed on the resultant structure by means of CVD. Phosphorus is diffused at 950°C, and the polysilicon film is rendered $N^+$ conductive. Then, the polysilicon film is patterned by means of PEP and reactive ion etching (RIE), thereby forming a gate electrode 111 of the P-channel MOS transistor and a gate electrode 112 of the N-channel MOS transistor. Using a photoresist pattern as a mask, boron ions are implanted to form a P⁻ diffusion layer 12 corresponding to an internal base region of the NPN transistor. Subsequently, using a photoresist pattern as a mask, the thin oxide film is selectively removed and arsenic ions (As) ions are implanted thereby forming a drain region $13_1$ and a source region (N⁺ region) $13_2$ of the N-channel MOS transistor.

The photoresist is removed and an oxidation treatment is performed at 900°C to form a thermal oxidation film (not shown). Using a photoresist pattern as a mask, boron ions are implanted thereby forming a P⁺ diffusion layer 141 corresponding to the external base region of the NPN transistor, and a drain region $142_1$ and a source region (P⁺ region) $142_2$ of the P-channel MOS transistor, as is shown in Fig. 2C. Then, using a photoresist pattern as a mask, arsenic (As) ions are implanted to form an N⁺ diffusion layer 15 in the emitter region of the NPN transistor. An undoped CVD oxide film and a boron-phosphor-silicated glass (BPSG) film are successively formed as an interlayer insulating film 16 by means of CVD. Then, melting and getter treatments are carried out at 950°C. Then, a contact region is formed by PEP, and, using the contact region as a mask, the interlayer insulating film 16 (BPSG film and undoped CVD oxide film) is etched by RIE, thereby forming an electrode contact hole. In order to form an electrode and a wiring layer of a metal or a metal compound, an aluminum-silicon (Aℓ-Si) layer with a thickness of, e.g. 8000 Å is formed by means of sputtering. This layer is patterned, thereby forming an emitter electrode 171 in contact with the emitter region 15 (N⁺ diffusion layer) of the NPN transistor; a base electrode 172 in contact with the base region (P⁺ diffusion layer) 141 of the NPN transistor; a collector electrode 173 in contact with the first deep N⁺ diffusion layer 61; a drain electrode $174_1$ and a source electrode $174_2$, respectively in contact with the drain region $142_1$ and source region $142_2$ (N⁺ region) of the P-channel MOS transistor; a drain electrode $175_1$ and a source electrode $175_2$, respectively in contact with the drain region $13_1$ and source region $13_2$ (N⁺ region) of the N-channel MOS transistor; and an electrode 176 in contact with the second deep N⁺ diffusion layer 62 surrounding the CMOS region.

Subsequently, a forming treatment is carried out at a temperature of 450°C to obtain desired characteristics. A surface protection film (not shown) is formed by means of CVD, and a bonding pad formation region is formed by means of PEP. Thus, the manufacturing process is completed.

According to the Bi-CMOS integrated circuit having the above-described structure, as is shown in Fig. 2C, the CMOS transistor is formed in the island-shaped N-epitaxial layer and P-well region, which is isolated from the remaining part of the semiconductor substrate. Thus, noise occurring in the CMOS circuit does not adversely affect the bipolar circuit.

Accordingly, the operation margin of the semiconductor integrated circuit increases and the malfunction is prevented. In addition, it is not necessary to make a special patterning, e.g. providing the power line and ground line separately for the bipolar circuit and the CMOS circuit, or separating both circuits with a sufficient distance. Thus, integration density can be increased, and the number of external pins can be decreased.

In addition, in the Bi-CMOS integrated circuit according to the above embodiment, an electrode is put in contact with the region for isolating the islandshaped CMOS transistor region from the remaining part.

The substrate potential of the island-shaped CMOS transistor region can be determined independently from the substrat potential of the other part.

Furthermore, the structure of this device is relatively simple, and the number of manufacturing steps can be reduced, compared to the conventional Bi-CMOS integrated circuit.

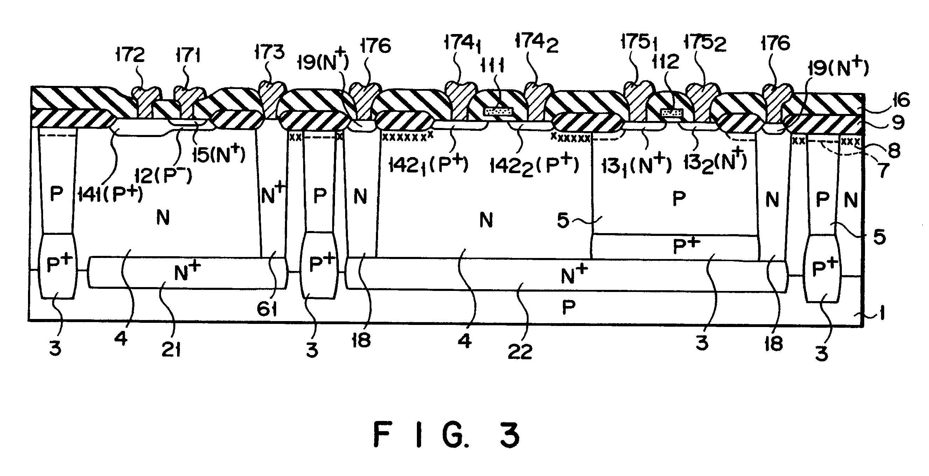

Fig. 3 is a cross-sectional view showing a structure of a Bi-CMOS integrated circuit according to another embodiment of the invention. This circuit differs from the circuit of Fig. 2C, only in that the second depp N⁺ diffusion layer 62 is replaced by an N-well diffusion layer 18 and an N⁺ diffusion layer 19 formed on the surface region of the layer 18. In Fig. 3, the structural elements already shown in Fig. 2C are denoted by the same reference numerals. The method of manufacturing the Bi-CMOS integrated circuit of Fig. 3 differs from that of manufacturing the circuit of Fig. 2C, in that the step of forming the second deep N⁺ diffusion layer 62 is replaced by the step of forming the N-well diffusion layer 18, and the N⁺ diffusion layer 19 is formed at the time of forming the drain region $13_1$ and source region $13_2$ (N⁺ diffusion layer) of the N-channel transistor.

As has been described above, according to the semiconductor integrated circuit wherein both a bipolar transistor and a CMOS transistor are formed on a single semiconductor chip, an island-shaped N-epitaxial layer is formed such that an island-shaped CMOS transistor region is isolated from the semiconductor subtrate and the other part. Thus, noise occurring in the CMOS circuit does not adversely affect the bipolar circuit. While the operation margin of the semiconductor integrated circuit is increased, the malfunction of the circuit can be prevented. In addition, it is not necessary to make special patterning, e.g. to provide the power line and ground line separately for the bipolar circuit and the CMOS circuit, or to separate both circuits with a sufficient distance. Thus, the integration density can be increased and the number of external pins can be reduced. Furthermore, since the electrode is formed in contact with the region for isolating the island-shaped CMOS transistor region from the other part, the substrate potential of the island-shaped CMOS transistor region can be determined independently from that of the other part.

Moreover, according to the method of manufacturing the semiconductor integrated circuit of the present invention, the semiconductor integrated circuit having the above features can be manufactured by the combination of the well-known processes.

Reference signs in the claims are intended for better understanding and shall not limit the scope.

## Claims

1. A semiconductor integrated circuit in which a bipolar transistor and an insulated gate type complementary transistor are formed on a single semiconductor chip, characterized in that said insulated gate type complementary transistor is formed in an island-shaped epitaxial layer which is completely isolated from a semiconductor substrate (1) and the other part of the circuit and which has a conductivity type (N) opposite to that (P) of the semiconductor substrate, and that an electrode (176) is formed in contact with a region (62) for isolating said island-shaped epitaxial layer from the other part of the circuit.

2. The circuit according to claim 1, characterized in that said insulated gate type complementary transistor is completely isolated from the other part of the circuit by a high-concentration buried layer (22), which is formed between said semiconductor substrate and said island-shaped epitaxial layer and has a conductivity type (N$^+$) opposite to that (P) of the semiconductor substrate, and a high-concentration diffusion layer (62), which is formed by means of impurity diffusion to extend from the surface of the epitaxial layer to said high-concentration buried layer and has the conductivity type (N$^+$) opposite to that (P) of the semiconductor substrate, and that an electrode (176) is formed in contact with a region of said high-concentration diffusion layer.

3. The circuit according to claim 1, characterized in that said insulated gate type complementary transistor is completely isolated from the other part of the circuit by a high-concentration buried layer (22), which is formed between said semiconductor substrate and said island-shaped epitaxial layer and has a conductivity type (N) opposite to that (P) of the semiconductor substrate, and a well diffusion layer (18), which is formed by means of impurity diffusion to extend from the surface of the epitaxial layer to said highconcentration buried layer and has the conductivity type (N) opposite to that (P) of the semiconductor substrate, and that an electrode (176) is formed in contact with a region of said well diffusion layer.

4. The circuit according to claim 1, characterized in that an N-channel transistor of said insulated gate type complementary transistor comprises:
an N-type high-concentration buried layer (22) formed in a P-type semiconductor substrate (1);
a P-type high-concentration layer formed on said buried layer (3);
a P-type well diffusion layer (5) formed by means of impurity diffusion to extend from the surface of the semiconductor substrate above the P-type highconcentration layer to said P-type high-concentration layer; and
a source region (132) and a drain region (131) formed in a surface portion of said P-type well diffusion layer.

5. The circuit according to claim 2, characterized in that an N-channel transistor of said insulated gate type complementary transistor comprises:
an N-type high-concentration buried layer (22) formed in a P-type semiconductor substrate (1);
a P-type high-concentration layer formed on said buried layer (3);
a P-type well diffusion layer (5) formed by means of impurity diffusion to extend from the surface of the semiconductor substrate above the P-type highconcentration layer to said P-type high-concentration layer; and
a source region (132) and a drain region (131) formed in a surface portion of said P-type well diffusion layer.

6. The circuit according to claim 3, characterized in that an N-channel transistor of said insulated gate type complementary transistor comprises:
an N-type high-concentration buried layer (22) formed in a P-type semiconductor substrate (1);
a P-type high-concentration layer formed on said buried layer (3);
a P-type well diffusion layer (5) formed by means of impurity diffusion to extend from the surface of the semiconductor substrate above the P-type highconcentration layer to said P-type high-concentration layer; and
a source region (132) and a drain region (131) formed in a surface portion of said P-type well diffusion layer.

7. A method of manufacturing a semiconductor integrated circuit in which a bipolar transistor and an insulated gate type complementary transistor are formed on a single semiconductor chip, said method characterized by comprising the steps of:

forming an island portion in an epitaxial layer formed in a surface portion of a semiconductor substrate (1) and having a conductivity type (N) opposite to that (P) of the semiconductor substrate, said island portion being isolated completely from the semiconductor substrate and the other part of the circuit;

forming an insulated gate type complementary transistor in said island portion in the epitaxial layer; and

forming an electrode (176) in contact with a region (62) for isolating said island portion from the other part of the circuit.

8. A method of manufacturing a semiconductor integrated circuit, said method characterized by com prising the steps of:

forming a first $N^+$ buried layer (21) and a second $N^+$ buried layer (22) in a P-type silicon substrate (1), said buried layers containing an N-type impurity at a high concentration;

forming a $P^+$ buried layer (3) on part of said second $N^+$ buried layer;

growing an N-type epitaxial layer (4) on said substrate;

forming a P-type well diffusion layer (5) in the N-type epitaxial layer on the $P^+$ buried layer; forming a first deep $N^+$ diffusion layer (61) in the N-type epitaxial layer, said first deep $N^+$ diffusion layer extending to the first $N^+$ buried layer, and forming a second deep $N^+$ diffusion layer (62) extending to the second $N^+$ buried layer and surrounding an insulated gate type complementary transistor region;

forming a field oxide film (9) selectively in a surface region of the substrate, said field oxide film serving to isolate elements;

forming a bipolar transistor in the N-type epitaxial layer on the first $N^+$ buried layer, a P-channel MOS transistor in the N-type epitaxial layer on the $N^+$ buried layer, and an N-channel MOS transistor in the P-type well diffusion layer on the second $N^+$ buried layer; and

forming an electrode (176) in contact with the second deep $N^+$ diffusionlayer.

9. A method of manufacturing a semiconductor integrated circuit, said method characterized by comprising the steps of:

forming a first $N^+$ buried layer (21) and a second $N^+$ buried layer (22) in a P-type silicon substrate (1), said buried layers containing an N-type impurity at a high concentration;

forming a $P^+$ buried layer (3) on part of said second $N^+$ buried layer;

growing an N-type epitaxial layer (4) on said substrate;

forming a P-type well diffusion layer (5) in the N-type epitaxial layer, said P-type well diffusion layer extending to the $P^+$ buried layer;

forming a deep $N^+$ diffusion layer (61) in the N-type epitaxial layer, said deep $N^+$ diffusion layer extending to the first $N^+$ buried layer, and forming an N-well diffusion layer (62) extending to the second $N^+$ buried layer and surrounding an insulated gate type complementary transistor region;

forming a field oxide film (9) selectively in a surface region of the substrate, said field oxide film serving to isolate elements;

forming a bipolar transistor in the N-type epitaxial layer on the first N + buried layer, a P-channel MOS transistor in the N-type epitaxial layer on the $N^+$ buried layer, and an N-channel MOS transistor in the P-type well diffusion layer on the second $P^+$ buried layer; and

forming an electrode (176) in contact with the N-well diffusion layer.

FIG. 1

FIG. 2A

F I G. 2B

F I G. 2C

F I G. 3